# EUROPEAN PATENT APPLICATION

(11) **EP 1 439 585 A1**
(43) Date of publication of application: **21.07.2004**
(21) Application number: 03001046.6
(22) Date of filing: 17.01.2003
(51) Int. Cl.: H01L 33/00

(54) **Light emitting diode comprising a phosphor layer**

(71) Applicant: Unity Opto Technology Co., Ltd., San Chung City, Taipei Hsien, Taiwan (TW)
(72) Inventor: Chin, Yuan-Cheng, Hsintien City, Taipei Hsien, Taiwan (TW); Lin, I-Hon, Changhua Hsien, Taiwan, R.O.C. (TW); Yang, Chih-Wei, Taipei, Taiwan, R.O.C. (TW)
(74) Representative: Winkler, Andreas, Dr.

(57) **Abstract**

A light emitting diode includes first and second electrical terminals of which the first terminal forms a support. A light emitting diode die is mounted on the support of the first terminal and is connected to the second terminal by a conductive wire for emitting a first light. An encapsulation is formed around the die. A phosphor layer is formed on the support and interposed between the die and the support. The phosphor receives a portion of the first light and in turn gives off a second light that is selectively different from the first light for combining with the first light that travels out of the encapsulation to control brightness and color of the light projecting out of the encapsulation. Thus, a stable lighting may be achieved and mass production of quality-controlled light emitting diodes is made possible.

## Description

### FIELD OF THE INVENTION

The present invention generally relates to the field of light emitting diodes (LEDs), and in particular to a light emitting diode comprising a phosphor layer for control of color and brightness of light emitted from the LED.

### BACKGROUND OF THE INVENTION

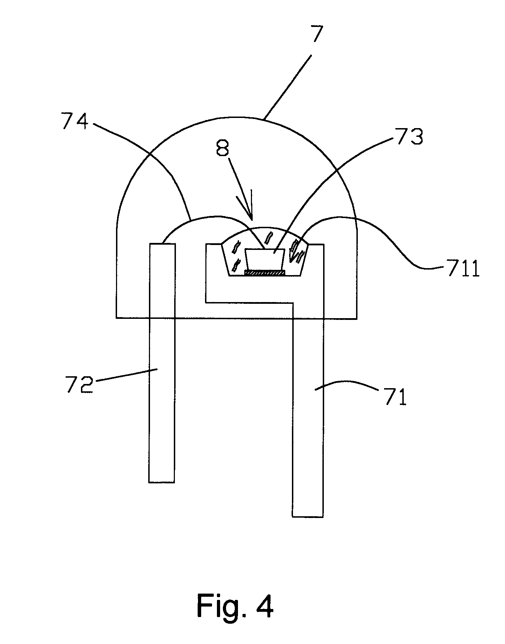

A general structure of a conventional light emitting diode (LED) is shown in Figure 4 of the attached drawings. The conventional LED comprises lead frames 71, 72 spaced from each other, serving as electrodes for the LED. The lead frame 71 forms a recess or cup 711 in which an LED die 73 is positioned. The die 73 is positioned on and bonded to a bottom of the cup 711. A conductive wire 74 connects the die 73 to the other lead frame 72. A phosphor-based material 8 is deposited into the cup 711 and surrounds the die 73 as an encapsulation of the LED. The phosphor-based material 8 is pumped by the die 73 to give off light of desired color.

The manufacturing process of the above-discussed conventional LED is sophisticated, requiring bonding the die 73 to the cup 711 of the lead frame 71 and connecting the die 73 with another lead frame 72 by a wire 74 and lastly, encapsulating the die 73 with a phosphor-based material 8. The phosphor-based material 8 that surrounds the die 73 causes undesired and adverse absorption of light from the die 73. Thus, control of the brightness and color of the light emitted from the LED is difficult and may often result in instability of color and brightness of the light. Consequently, mass production of the LEDs cannot be effectively performed.

Thus, it is desired to have a structure of LED that overcomes the above problems.

### SUMMARY OF THE INVENTION

An object of the present invention is to provide a light emitting diode that provides color-modified, brightness-enhanced and stable lighting.

Another object of the present invention is to provide a light emitting diode having a structure suitable for mass production and effectively controlling color and brightness of light emitted therefrom.

To achieve the above objects, in accordance with the present invention, there is provided a light emitting diode (LED) comprising first and second electrical terminals of which the first terminal forms a support. A light emitting diode die is mounted on the support of the first terminal and is connected to the second terminal by a conductive wire for emitting a first light. An encapsulation is formed around the die. A phosphor layer is formed on the support and interposed between the die and the support. The phosphor receives a portion of the first light and in turn gives off a second light that is selectively different from the first light for combining with the first light that travels out of the encapsulation to control brightness and color of the light projecting out of the encapsulation. Thus, a stable lighting may be achieved and mass production of quality-controlled light emitting diodes is made possible.

### BRIEF DESCRIPTION OF THE DRAWINGS

The present invention will be apparent to those skilled in the art by reading the following description of the preferred embodiments thereof, with reference to the attached drawings, in which:

Figure 1 is a schematic side elevational view of a light emitting diode constructed in accordance with a first embodiment of the present invention;

Figure 2 is a schematic side elevational view of a light emitting diode constructed in accordance with a second embodiment of the present invention;

Figure 3 is a schematic side elevational view of a light emitting diode constructed in accordance with a third embodiment of the present invention; and

Figure 4 is a schematic side elevational view of a conventional light emitting diode.

### DETAILED DESCRIPTION OF THE PREFERRED EMBODIlVIENTS

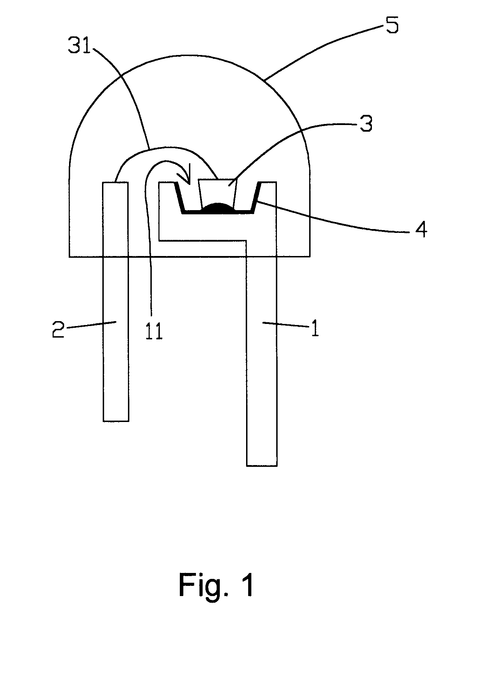

With reference to the drawings and in particular to Figure 1, a light emitting diode (LED) constructed in accordance with a first embodiment of the present invention comprises a first lead frame 1 and a second lead frame 2 spaced from each other and forming electrodes of different electrical polarities for the LED. A recess or cup 11 is formed on an upper end of the first lead frame 1 and receives an LED die 3 therein. A conductive wire 31 connects the die 3 to the second lead frame 2. An encapsulation 5 is formed and surrounds ends of the lead frames 1, 2 and the die 3.

In accordance with the present invention, a phosphor layer 4 is formed on an inside surface of the cup 11 and is interposed between the die 3 and the cup 11. The phosphor layer 4 is comprised of a mixture of a die bonding adhesive and a solid-state luminance material. The die bonding adhesive may be conductive or non-conductive. An example is epoxy. The solid-state luminance material may comprise phosphor powders mixed in the die bonding adhesive. Light generated by the die 3 is partially projected onto the phosphor layer 4, stimulating the phosphor layer 4 to give off a second light, which may be different from the light from the die 3. The color of the second light is dependent upon the phosphor substance mixed in the phosphor layer 4. For example, the die 3 may emit a blue light, while the phosphor layer 4 receives the blue light and in turn gives off a yellow light. Both the blue light and the yellow lights travel through the encapsulation 5 and project outward. The mixture of the blue and yellow lights gives a white light. Thus, the LED of the present invention may give off white light. The yellow light from the phosphor layer 4 may also be used to control the brightness of the final light projecting out of the encapsulation 5.

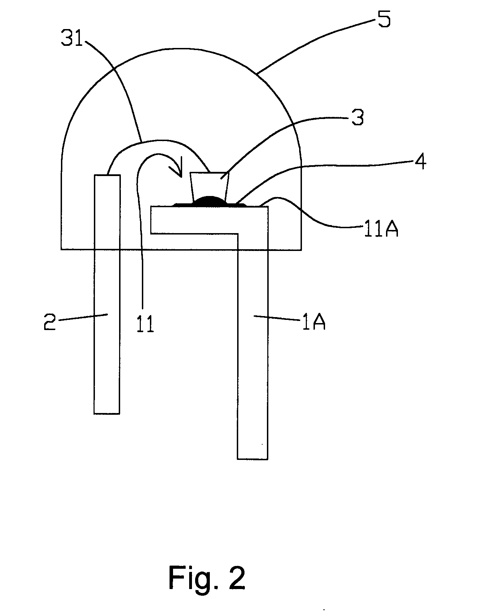

Figure 2 shows a light emitting diode constructed in accordance with a second embodiment of the present invention, comprising a first lead frame 1A forming a support platform 11A having a flat surface (not labeled) on which a phosphor layer 4 is coated. The phosphor layer 4 is comprised of a die bonding adhesive and phosphor powders mixed together. An LED die 3 is attached to the phosphor layer 4 and is connected to a second lead frame 2 by a conductive wire 31. An encapsulation 5 is then formed around the die 3 and the phosphor layer 4. Similarly, light emitted from the die 3 is partly projected onto the phosphor layer 4, which in turn gives off a second light that may be different from the light from the die 3. Thus, the phosphor layer 4 allows for control of brightness and color of the light eventually projecting out of the encapsulation 5 and a stable lighting may be obtained with the light emitting diode. As a consequence, mass production of quality-controlled light emitting diodes is made possible.

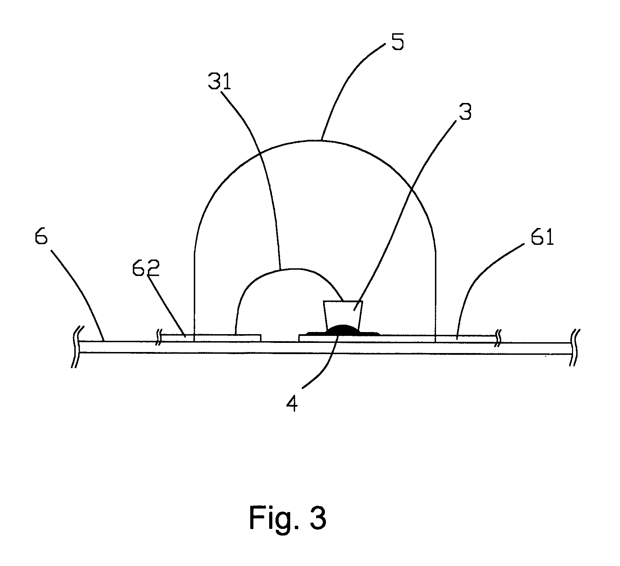

Figure 3 shows a light emitting diode constructed in accordance with a third embodiment of the present invention, which is directly mounted to a circuit board 6. The light emitting diode of the third embodiment comprises a first conductive trace 61 and a second conductive trace 62 formed on the circuit board 6 and spaced from each other and connected to opposite electrical terminals of a power source. A phosphor layer 4 is coated on the first conductive trace 61. The phosphor layer 4 is comprised of a die bonding adhesive and phosphor powders mixed together. An LED die 3 is attached to the phosphor layer 4 and is connected to the second conductive trace 62 by a conductive wire 31. An encapsulation 5 is then formed around the die 3 and the phosphor layer 4. Similarly, light emitted from the die 3 is partly projected onto the phosphor layer 4, which in turn gives off a second light that may be different from the light from the die 3. Thus, the phosphor layer 4 allows for control of brightness and color of the light eventually projecting out of the encapsulation 5 and a stable lighting may be obtained with the light emitting diode. As a consequence, mass production of quality-controlled light emitting diodes is made possible.

Although the present invention has been described with reference to the preferred embodiments thereof, it is apparent to those skilled in the art that a variety of modifications and changes may be made without departing from the scope of the present invention which is intended to be defined by the appended claims.

## Claims

1. A light emitting diode comprising:
first and second electrical terminals, the first terminal forming a support;
a light emitting diode die mounted on the support of the first terminal and being connected to the second terminal by a conductive wire for emitting a first light; and
an encapsulation formed around the die;
the improvements comprising a phosphor layer formed on the support and interposed between the die and the support, the phosphor layer receiving a portion of the first light and in turn giving off a second light that is selectively different from the first light for combining with the first light that travels out of the encapsulation to control brightness and color of light projecting out of the encapsulation.

2. The light emitting diode as claimed in Claim 1, wherein the phosphor layer is formed with a mixture of a die bonding adhesive and a solid-state luminance material.

3. The light emitting diode as claimed in Claim 2, wherein the die bonding adhesive is conductive.

4. The light emitting diode as claimed in Claim 2, wherein the die bonding adhesive is non-conductive.

5. The light emitting diode as claimed in Claim 2, wherein the solid-state luminance material comprises phosphor powders.

6. The light emitting diode as claimed in Claim 1, wherein the support defines a recess having an inside surface on which the phosphor layer is coated, the die being received in the recess.

7. The light emitting diode as claimed in Claim 1, wherein the support forms a flat surface on which the phosphor layer is coated, the die being positioned on the phosphor layer.

8. The light emitting diode as claimed in Claim 1, wherein the first and second terminals comprise first and second lead frames spaced from each other.

9. The light emitting diode as claimed in Claim 1, wherein the first and second terminals are formed by conductive traces coated on a circuit board and spaced from each other.
